## Europäisches Patentamt
## European Patent Office
## Office européen des brevets

(19)

(11) Veröffentlichungsnummer : **0 075 874 B1**

(12)
# EUROPÄISCHE PATENTSCHRIFT

(45) Veröffentlichungstag der Patentschrift : 23.12.87

(51) Int. Cl.⁴ : **H 01 L 21/31, H 01 L 21/90**

(21) Anmeldenummer : **82108814.3**

(22) Anmeldetag : **23.09.82**

(54) Verfahren zur Erzeugung elektrisch leitender Schichten.

(30) Priorität : **30.09.81 DE 3138960**

(43) Veröffentlichungstag der Anmeldung : **06.04.83 Patentblatt 83/14**

(45) Bekanntmachung des Hinweises auf die Patenterteilung : **23.12.87 Patentblatt 87/52**

(84) Benannte Vertragsstaaten : **AT CH DE FR GB IT LI**

(56) Entgegenhaltungen :
**FR-A- 2 263 608
FR-A- 2 282 163
US-A- 4 043 024**

(73) Patentinhaber : **Siemens Aktiengesellschaft Berlin und München
Wittelsbacherplatz 2
D-8000 München 2 (DE)**

(72) Erfinder : **Dathe, Joachim, Dipl.-Phys.
Schleissheimer Strasse 276
D-8000 München 40 (DE)**
Erfinder : **Holtschmidt, Walter
Hausnerstrasse 118
D-8011 Kirchheim (DE)**

Jouve, 18, rue St-Denis, 75001 Paris, France

## Beschreibung

Die Erfindung betrifft ein Verfahren zur Erzeugung einer elektrisch halbisolierenden Schicht nach dem Oberbegriff des Anspruchs 1. Ein solches Verfahren ist aus DE-A-29 44 937 bekannt.

Die Erzeugung elektrisch leitender Schichten auf bzw. in Isolationsschichten ist bei der Herstellung verschiedener elektrischer Bauelemente von großer Wichtigkeit. So ist es bei Halbleiterbauelementen wie z. B. integrierten Schaltungen sehr wichtig, hohe Widerstände zwischen metallischen Leitern bzw. Leitbahnen mit geringem Platzbedarf anzubringen.

Außerdem läßt sich durch Anbringung einer leitfähigen Schicht oberhalb einer isolierenden Oberflächenpassivierung eine abschirmende Wirkung gegenüber ionogenen Verunreinigungen auf der Oberfläche erreichen, wodurch sich z. B. eine gute Passivierung von planaren Halbleiterbauelementen erreichen läßt.

Durch die Anbringung einer leitenden Schicht über einer Isolatorschicht läßt sich auch die Durchbruchspannung von insbesondere sehr flach diffundierten planaren Halbleiteranordnungen dadurch vergrößern, daß an verschiedenen Stellen elektrische Potentiale angelegt werden. Eine elektrisch leitende Schicht auf einer Isolatorschicht wird nach der deutschen Anmeldung P 29 44 937.4 auf einem Halbleiterbauelement dadurch erzeugt, daß die mit einer Isolierschicht überdeckte Halbleiteroberfläche nochmals mit einem halbisolierenden Film, z. B. durch Aufbringen eines amorphen Siliciumfilms, überdeckt wird. Die Anbringung eines leitfähigen Films über einem Isolatorfilm ist, wie gezeigt wurde, insbesondere bei speziellen Anwendungen am Halbleitersektor von besonderer Wichtigkeit. Bei der Wahl eines hierfür geeigneten Verfahrens ist bei Halbleiterbauelementen allgemein stets zu beachten, daß besonders hohe Temperaturschritte möglichst vermieden werden, da diese im allgemeinen die ursprüngliche Qualität des Halbleiterbauelementes vermindern. Insbesondere im Hinblick auf das Anbringen von Widerständen in Isolatorschichten ist es auch wichtig, diese mit bestimmten Leitfähigkeitswerten erzeugen zu können. Bei der Auswahl eines geeigneten Verfahrens ist es wichtig, auf das gleichzeitige Vorhandensein geeigneter und leicht anwendbarer Maskierungsverfahren zu achten. Schließlich ist es bei der Herstellung von Halbleiterbauelementen wichtig, daß Passivierungsverfahren am Endes eines Herstellungsprozesses durchgeführt werden können und daß eine herzustellende leitfähige Schicht so angebracht ist, daß sie gegen Umgebungseinflüsse geschützt ist.

Der vorliegenden Erfindung liegt die Aufgabe zugrunde, ein Verfahren nach dem Oberbegriff des Anspruchs 1 anzugeben, bei dem die Durchbruchspannung insbesondere bei sehr flachdiffundierten planaren Halbleiteranordnungen weiter erhöht werden kann.

Diese Aufgabe wird erfindungsgemäß durch ein Verfahren nach dem Anspruch 1 gelöst.

Durch ein Verfahren nach der Erfindung kann die Durchbruchspannung gegenüber dem Stand der Technik erhöht werden. Ein Verfahren nach der Erfindung ist einfacher und auch vorteilhafter als ein Verfahren nach dem Stand der Technik, da die Leitfähigkeit der implantierten Schicht einstellbar ist und da eine solche leitende Schicht, weil sie versenkt in der Isolatorschicht angebracht wird, keiner weiteren Passivierung bedarf.

Aus US-A-4 043 024 ist ein Verfahren zur Erzeugung elektrisch leitender Schichten bekannt, bei dem eine eingelagerte, potentialmäßig schwimmende Torelektrode erzeugt wird, die nicht zur Erhöhung der Durchbruchspannung dient und die auch nicht Kontakte ein und desselben Halbleiterbauelements elektrisch unmittelbar verbindet. Wenn die eingelagerte Torelektrode ungeladen ist, besteht kein Kanal, d. h. keine leitfähige Verbindung zwischen Drain und Source. Sobald das Tor geladen wird, entsteht ein Kanal. Die Aufladung des Tors erfolgt durch heiße Elektronen aus dem Lawinendurchbruch.

Gemäß FR-A-2 263 608 werden passive Bauelemente erzeugt, welche zur Verbindung elektrischer Schaltkreise dienen. Bei einem Herstellungsverfahren nach dieser Veröffentlichung wird mit Zink oder mit Blei implantiert, wodurch eine Durchbruchspannung nicht erhöht werden würde, sondern wodurch vielmehr, weil diese Metallionen beispielsweise als Rekombinationszentren wirken, die Eigenschaften der Passivierungsschicht verschlechtert und damit die Durchbruchspannung erniedrigt werden würden. Beim Tempern werden bei einem Verfahren nach dieser Veröffentlichung die Widerstandswerte niedriger, während bei der vorliegenden Erfindung durch eine bei der Temperung erfolgende Rekristallisation der Widerstand erhöht werden kann, was bezüglich der Implantationsparameter günstiger ist.

Ein Verfahren nach der Erfindung vermeidet hohe Temperaturschritte, läßt eine Dosierung der Leitfähigkeit zu, gewährleistet eine leichte und problemlose Maskierung, kann am Ende eines Halbleiterherstellungsverfahrens angebracht werden und gewährleistet, daß die erzeugte elektrisch leitende Schicht vor Umgebungseinflüssen geschützt ist.

Durch die Anwendung der Ionenimplantation wird in vorteilhafter Weise ein Temperaturschritt eingespart. Außerdem läßt sich in der implantierten Schicht vorteilhaft eine vorgegebene Leitfähigkeit erzeugen, da die Menge der implantierten Ionen leicht dosiert werden kann. Die nicht zu implantierende Halbleiteroberfläche ist mittels einer Fotolackmaske leicht abdeckbar, was ein technisch einfaches Verfahren gewährleistet. Die Implantation kann am Ende eines Halbleiterherstellungsverfahrens angebracht werden, wodurch ein günstiger Ablauf der Herstellungsverfahrens gegeben ist. In Abhängigkeit von der Energie der zur Implantation verwendeten Ionen ist die leitfähige Schicht in verschiedenen Tiefen der Isolatorschicht anbringbar, wobei die leitfähige Schicht im Inneren der Isolatorschicht gleichzeitig gegen Umwelteinflüsse geschützt ist.

Mit dem erfindungsgemäßen Verfahren lassen sich z. B. sehr hohe Widerstände zwischen metallischen Leitern bzw. Leitbahnen bei geringem Platzbedarf leicht herstellen, was z. B. bei der Herstellung von Schaltkreisen von großer Bedeutung ist.

Zur Erhöhung der Durchbruchspannung insbesondere bei sehr flach diffundierten planaren Halbleiteranordnungen kann eine in eine Isolatorschicht implantierte leitende Schicht ähnlich eingesetzt werden, wie eine z. B. auf einer isolierenden Schicht abgeschiedene Siliciumschicht nach DE-A-29 44 937.

Eine erfindungsgemäß angebrachte leitende Schicht bewirkt in einer Isolationsschicht zugleich eine Passivierung der Oberfläche, da durch die leitende Schicht eine abschirmende Wirkung für die darunter liegenden Schichten gegenüber ionogenen Verunreinigungen auf der Oberfläche erreicht wird.

Die Ionenimplantation kann mittels Metall- oder Halbleiterionen, insbesondere mittels Siliciumionen erfolgen.

Es ist auch vorteilhaft, daß die Implantationsdosis $1 \cdot 10^{14}$ cm$^{-2}$ bis $1 \cdot 10^{18}$ cm$^{-2}$, insbesondere $1 \cdot 10^{17}$ cm$^{-2}$ beträgt und daß die Implantation mit einer Beschleunigungsspannung von 20 keV bis 300 keV, insbesondere von 30 keV erfolgt.

Weiterhin ist es vorteilhaft, daß als Isolatorschicht, Schichten aus mindestens einem der nachfolgenden Materialien: Aluminiumoxid ($Al_2O_3$), Siliciumdioxid ($SiO_2$), Phosphorglas ($SiO_2 \cdot P_2O_5$), Borglas ($SiO_2 \cdot B_2O_3$), insbesondere Siliciumnitrid ($Si_3N_4$) verwendet werden.

Weiterhin ist es vorteilhaft, daß die Schichtdicke der oberen Isolatorschicht 30 nm bis 300 nm (300 Å bis 3 000 Å), insbesondere 100 nm (1 000 Å) beträgt und bei der Implantation in die Isolatorschicht das Si-Konzentrationsmaximum sich in einem Abstand von — 0 nm bis 300 nm (0 Å bis 3 000 Å) insbesondere 20 nm (200 Å) unterhalb der äußeren Isolatoroberfläche 14 befindet.

Schließlich ist es auch vorteilhaft, daß im Anschluß an die Implantation eine Temperung vorgesehen ist und daß die Temperung in Stickstoff- oder Wasserstoff-atmosphäre durchgeführt wird und daß beim Tempern Temperaturen von 230 °C bis 650 °C insbesondere von 320 °C bis 420 °C angewendet werden und daß die Dauer der Temperung mindestens 30 Minuten beträgt.

Nachfolgend wird die Erfindung an einem Ausführungsbeispiel und der zeichnung näher erläutert.

Es zeigen :

Fig. 1 ein schematischer Querschnitt durch eine erfindungsgemäß hergestellte leitende Schicht

Fig. 2 die Verteilung der implantierten Ionen mit zunehmender Tiefe

Fig. 3 und Fig. 4 verschiedene Anwendungsbeispiele.

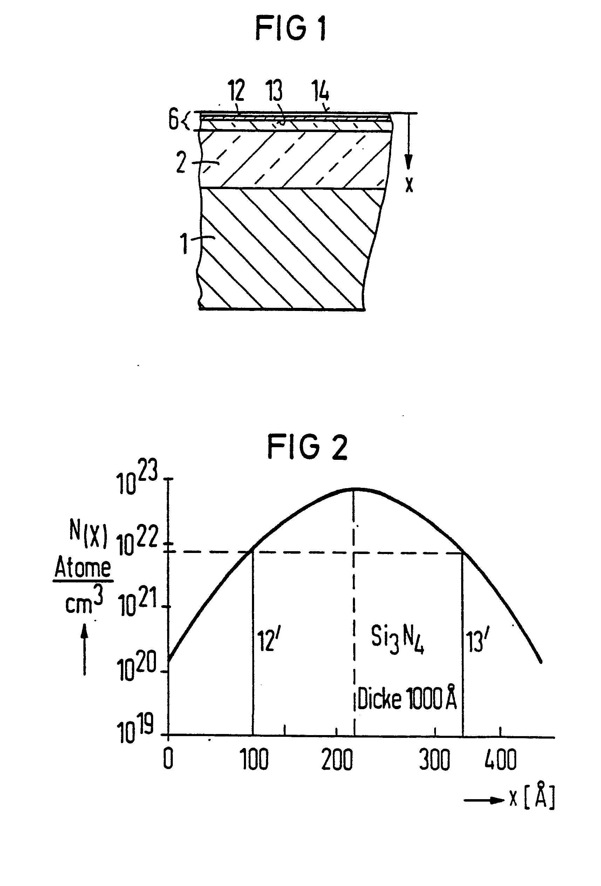

Figur 1 zeigt ein Substrat 1 bestehend aus einem insbesondere halbleitenden Material wie silicium, Germanium (Ge), Galliumarsenid (GaAS), das mit einer ersten Isolatorschicht 2 z. B. bestehend aus $SiO_2$ beschichtet ist. Darüber ist eine zweite Isolatorschicht 6 abgeschieden, die z. B. aus Aluminiumoxid ($Al_2O_3$), Phosphorglas ($SiO_2 \cdot P_2O_5$), Borglas ($SiO_2 \cdot B_2O_3$) oder aus Siliciumnitrid ($Si_3N_4$) bestehen kann.

Zur Implantation in die Schicht 6 können Metall- oder Halbleiterionen insbesondere Siliciumionen verwendet werden.

Im Bereich zwischen den Linien 12 und 13 weist die Schicht 6 eine durch die Implantation bewirkte Leitfähigkeit auf. Die Eindringtiefe der Implantierten Ionen wird von der Oberfläche 14 der Isolatorschicht 6 in Richtung des Pfeiles x gemessen.

Zur Erzeugung einer Siliciumschicht in einer z. B. 100 nm (1 000 Å) dicken Siliciumnitridschicht 6 nach Figur 1 in einer mittleren Tiefe von 20 nm (200 Å) und mit einer maximalen Konzentration von ca. $5 \cdot 10^{22}$ Atomen/cm$^3$, werden Siliciumionen mit der Dosis $1 \cdot 10^{17}$ cm$^{-2}$ bei einer Teilchenbeschleunigung von 30 keV implantiert.

Durch die Verwendung einer geringeren Teilchenbeschleunigung kann der Dotierungspeak näher zur Oberfläche 14 verlagert werden. Eine höhere Teilchenbeschleunigung verlagert den Dotierungspeak hingegen tiefer ins Innere der Schicht 6.

In Figur 2 ist die Verteilung der Siliciumionen in einer solchen Siliciumnitridschicht in Abhängigkeit von der Eindringtiefe x in diese Schicht dargestellt. Die maximale Implantationskonzentration liegt 220 Å unterhalb der Oberfläche 14 (Figur 1). Der leitfähige Bereich begrenzt durch die Linien 12 und 13 in Figur 1 wird in Figur 2 durch die Linien 12' und 13' dargestellt. Die Siliciumkonzentration beträgt in diesem Bereich mindestens $9 \cdot 10^{21}$ Atome/cm$^3$. Der leitfähige Bereich befindet sich in einer Tiefe zwischen 10 nm (100 Å) und 35 nm (350 Å) unterhalb der Oberfläche 14. Durch eine nachfolgende Temperung von insbesondere 30 Minuten Dauer bei einer Temperatur von insbesondere 320 Grad Celsius kann der spezifische Widerstand der erfindungsgemäß hergestellten implantierten Schicht um den Faktor 10 erhöt werden, da eine Rekristalisation stattfindet. Für das beschriebene Ausführungsbeispiel ergibt sich als Widerstandswert für die erfindungsgemäß hergestellte implantierte Isolatorschicht ein Wert von $10^7$ Ohm $\cdot$ cm. Der Stromfluß durch eine erfindungsgemäß hergestellte implantierte Isolatorschicht zeigt im gesamten Spannungsbereich ohm'sches Verhalten.

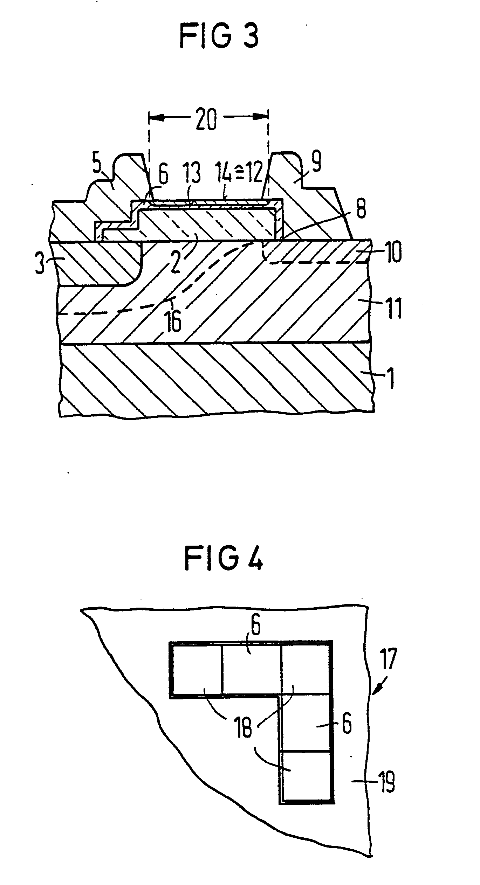

Figur 3 zeigt einen Querschnitt durch einen Teil eines Halbleiterbauelements mit einer nach dem erfindungsgemäßen Verfahren implantierten Si-Schicht in den zweiten Isolatorschicht 6 zur Erhöhung der Durchbruchspannung des pn-Überganges. Auf einem Substrat 1 z. B. aus Halbleitermaterial insbesondere aus Silicium befindet sich eine z. B. n-dotierte Siliciumschicht 11, in welche ein p-dotierter Bereich 3 und ein n + - dotierter Bereich 10 eingebracht sind. Auf der Oberfläche 8 der Schicht 11 sind eine erste Isolatorschicht 2 und darüber eine zweite Isolatorschicht 6 aufgebracht. Die zweite Isolatorschicht 6 kann z. B. aus Aluminiumoxyd ($Al_2O_3$), Phosphorglas ($SiO_2 \cdot P_2O_5$), Borglas ($SiO_2 \cdot B_2O_3$) oder insbesondere Siliciumnitrid ($Si_3N_4$) bestehen, während die erste Isolatorschicht 2 aus Siliciumdioxid ($SiO_2$) besteht. Zum Anschluß des p-dotierten Bereichs 3 und des n + — dotierten Bereichs 10 sind mittels Fototechnik Fensteröffnungen in die beiden Isolatorschichten eingebracht, die bis zur Halbleiteroberfläche 8 reichen. Durch eine nachfolgende Abscheidung von Kontaktmaterial z. B. Aluminium und eine weitere Fototechnik zur Ausbildung des speziellen Kontaktmusters entstehen die Kontakte 5 und 9, während die zweite Isolatorschicht 6 im Bereich 20 von Kontaktmaterial frei ist. Eine nachfolgende ganzflächige Implantation z. B. mittels Silicium und z. B. mittels den bei Figur 2 beschriebenen Parametern erzeugt im Bereich 20 der zweiten Isolatorschicht 6 eine leitfähige Schicht, die nach einer Temperung von 30 Minuten bei 320 °C ein Widerstand von ca. $10^7$ Ohm · cm aufweist. Durch diese Schicht sind die Kontakte 5 und 9 durch einen hochohmigen Widerstand verbunden. Liegen die Kontakt 5 und Kontakt 9 auf unterschiedlichen Potentialen z. B. wenn Kontakt 5 Basisanschluß eines Transistors und Kontakt 9 Anschluß für einen Channelstopper ist, so erhält die Raumladungszone im inneren der n-dotierten Siliciumschicht 11 einen durch eine gestrichelte Kurve 16 angedeuteten Verlauf, der sich durch sehr große Krümmungsradien auszeichnet, so daß ein mittels des erfindungsgemäßen Verfahrens hergestelltes Halbleiterbauelement eine große Durchbruchsspannung besitzt.

Figur 4 zeigt eine Draufsicht auf einen Teil eines Halbleiterchips 17, das Kontaktflecke 18 z. B. bestehend aus Aluminium aufweist, die z. B. zu speziellen Anschlüssen einer integrierten Schaltung gehören. Zwischen den Kontaktflecken 18 sind in Isolatorbereiche 6 implantierte Si-Bereiche als hochohmige Widerstände (z. B. Dämpfungswiderstände) eingebracht. Zur Anbringung derartiger hochohmiger Widerstände wird die gesamte Halbleiteroberfläche mit Ausnahme sowohl derjenigen Bereiche die mit hochohmigen Widerständen versehen werden sollen, wie auch der Andschlußbereich in die Kontaktflecken 18, mit einer Fotolackmaske 19 maskiert. Danach kann eine ganzflächige Implantation des Halbleiterchips 17 z. B. mit Siliciumionen und z. B. mittels den bei Figur 2 angegebenen Parametern erfolgen.

Die Erfindung ist auf die angeführten Ausführungsbeispiele sowie auf die angegebenen Materialien und Dotierungen nicht beschränkt.

### Patentansprüche

1. Verfahren zur Erzeugung einer elektrisch halbisolierenden Schicht oberhalb der Oberfläche eines planaren Halbleiterbauelements, wobei die oberfläche des Halbleiterbauelements mit einer isolatorschicht versehen ist, wobei die halbisolierende Schicht zur Erhöhung der Durchbruchspannung zwei Kontakte des Halbleiterbauelements, die auf unterschiedlichen Potentialen liegen, elektrisch verbindet, dadurch gekennzeichnet, daß die halbisolierende Schicht im Inneren der isolatorschicht erzeugt wird und daß die Leitfähigkeit von mindestens einem Teil der Isolatorschicht durch Ionenimplantation mittels Halbleiterionen erfolgt.

2. Verfahren nach Anspruch 1, dadurch gekennzeichnet, daß die Implantation mittels Siliciumionen erfolgt.

3. Verfahren nach einem der Ansprüche 1 oder 2, dadurch gekennzeichnet, daß die Implantationsdosis $1 \cdot 10^{14}$ cm$^{-2}$ bis $1 \cdot 10^{18}$ cm$^{-2}$, insbesondere $1 \cdot 10^{17}$ cm$^{-2}$ beträgt.

4. Verfahren nach einem der Ansprüche 1 bis 3, dadurch gekennzeichnet, daß die Implantation mit einer Beschleunigungsspannung von 20 keV bis 300 keV, insbesondere von 30 keV erfolgt.

5. Verfahren nach einem der Ansprüche 1 bis 4, dadurch gekennzeichnet, daß als Isolatorschicht (6) Schichten aus mindestens einem der nachfolgenden Materialien Aluminiumoxid ($Al_2O_3$), Siliciumdioxid ($SiO_2$), Phosphorglas ($SiO_2 \cdot P_2O_5$), Borglas ($SiO_2 \cdot B_2O_3$), insbesondere Siliciumnitrid ($Si_3N_4$) verwendet werden.

6. Verfahren nach einem der Ansprüche 1 bis 5, dadurch gekennzeichnet, daß die Schichtdicke der Isolatorschicht (6) 30 nm bis 300 nm (300 Å bis 3 000 Å) insbesondere 100 nm (1 000 Å) beträgt.

7. Verfahren nach einem der Ansprüche 1 bis 6, dadurch gekennzeichnet, daß bei der Ionenimplantation der Isolatorschicht (6) das Dosismaximum sich in einem Abstand von — 0 nm bis 300 nm (0 Å bis 3 000 Å), insbesondere von 20 nm (200 Å) unterhalb der äußeren Isolatoroberfläche (14) befindet.

8. Verfahren nach einem der Ansprüche 1 bis 7, dadurch gekennzeichnet, daß im Anschluß an die Implantation eine Temperung vorgesehen ist.

9. Verfahren nach Anspruch 8, dadurch gekennzeichnet, daß die Temperung in Stickstoff oder Wasserstoffatmosphäre durchgeführt wird.

10. Verfahren nach einem der Ansprüche 8 oder 9, dadurch gekennzeichnet, daß beim Tempern Temperaturen von 230 °C bis 650 °C, insbesondere von 320 °C bis 420 °C angewendet werden.

11. Verfahren nach einem der Ansprüche 8 bis 10, dadurch gekennzeichnet, daß die Dauer der Temperung mindestens 30 Minuten beträgt.

### Claims

1. A process for the production of an electrically semi-insulating layer above the surface of a planar semiconductor component, where the surface of the semiconductor component is provided with an insulating layer, and where, in order to increase the breakdown voltage, the semi-insulating layer electrically connects two contacts of the semiconductor component which carry different potentials, characterised in that the semi-insulating layer is produced in the interior of the insulating layer ; and that the conductivity of at least a part of the insulating layer results from ion implantation using semiconductor ions.

2. A process as claimed in Claim 1, characterised in that the implantation is carried out using silicon ions.

3. A process as claimed in Claim 1 or 2, characterised in that the implantation dose is $1 \cdot 10^{14}$ cm$^{-2}$ to $1 \cdot 10^{18}$ cm$^{-2}$, in particular $1 \cdot 10^{17}$ cm$^{-2}$.

4. A process as claimed in one of Claims 1 to 3, characterised in that the implantation is carried out at an accelerating voltage of 20 keV to 300 keV, in particular 30 keV.

5. A process as claimed in one of Claims 1 to 4, characterised in that as insulating layer (6), layers are used made of at least one of the following materials : aluminium oxide ($Al_2O_3$), silicon dioxide ($SiO_2$), phosphorus glass ($SiO_2 \cdot P_2O_5$), boron glass ($SiO_2 \cdot B_2O_3$), but in particular, silicon nitride ($Si_3N_4$).

6. A process as claimed in one of Claims 1 to 5, characterised in that the thickness of the insulating layer (6) is 30 nm to 300 nm (300 Å to 3 000 Å), in particular 100 nm (1 000 Å).

7. A process as claimed in one of Claims 1 to 6, characterised in that in the ion implantation of the insulating layer (6), the maximum dose occurs at a distance of 0 nm to 300 nm (0 Å to 3 000 Å), in particular 20 nm (200 Å), below the outer insulation surface (14).

8. A process as claimed in one of Claims 1 to 7, characterised in that annealing is carried out after the implantation.

9. A process as claimed in Claim 8, characterised in that the annealing is carried out in a nitrogen or hydrogen atmosphere.

10. A process as claimed in Claim 8 or 9, characterised in that temperatures of 230 °C to 650 °C, in particular 320 °C to 420 °C, are employed during the annealing.

11. A process as claimed in one of Claims 8 to 10, characterised in that the duration of the annealing is at least 30 minutes.

**Revendications**

1. Procédé pour fabriquer une couche semi-isolante du point de vue électrique, sur la surface d'un composant à semiconducteurs planar, selon lequel la surface du composant semiconducteur est munie d'une couche isolante et selon lequel, pour accroître la tension de claquage, la couche semi-isolante relie électriquement deux contacts du composant à semiconducteurs, qui sont placés à des potentiels différents, caractérisé par le fait qu'on réalise la couche semi-isolante à l'intérieur de la couche isolante et que la conductibilité d'au moins une partie de la couche isolante est obtenue au moyen d'une implantation ionique à l'aide d'ions d'un semiconducteur.

2. Procédé suivant la revendication 1, caractérisé par le fait que l'implantation est réalisée à l'aide d'ions de silicium.

3. Procédé suivant l'une des revendications 1 ou 2, caractérisé par le fait que la dose d'implantation est comprise entre $1 \cdot 10^{14}$ cm$^{-2}$ et $1 \cdot 10^{18}$ cm$^{-2}$ et est égale notamment à $1 \cdot 10^{17}$ cm$^{-2}$.

4. Procédé suivant l'une des revendications 1 à 3, caractérisé par le fait que l'implantation s'effectue avec une tension accélératrice comprise entre 20 keV et 300 keV et égale notamment à 30 keV.

5. Procédé suivant l'une des revendications 1 à 4, caractérisé par le fait qu'on utilise, comme couche isolante (6), des couches constituées par au moins l'un des matériaux suivants : oxyde d'aluminium ($Al_2O_3$), bioxyde de silicium ($SiO_2$), verre au phosphore ($SiO_2 \cdot P_2O_5$), verre au bore ($SiO_2 \cdot B_2O_3$), notamment du nitrure de silicium ($Si_3N_4$).

6. Procédé suivant l'une des revendications 1 à 5, caractérisé par le fait que l'épaisseur de la couche isolante (6) est comprise entre 30 nm et 300 nm (300 Å et 3 000 Å) et est égale notamment à 100 nm (1 000 Å).

7. Procédé suivant l'une des revendications 1 à 6, caractérisé par le fait que, lors de l'implantation ionique pour la formation de la couche isolante (6), la dose maximale est située à une distance comprise entre 0 nm et 300 nm (0 Å et 3 000 Å) et égale notamment à 20 nm (200 Å), au-dessous de la surface isolante extérieure (14).

8. Procédé suivant l'une des revendications 1 à 7, caractérisé par le fait qu'à la suite de l'implantation on réalise un recuit.

9. Procédé suivant la revendication 8, caractérisé par le fait que le recuit est exécuté dans une atmosphère d'azote ou d'hydrogène.

10. Procédé suivant l'une des revendications 8 ou 9, caractérisé par le fait que lors du recuit, on utilise des températures comprises entre 230 °C et 650 °C et notamment entre 320 °C et 420 °C.

11. Procédé suivant l'une des revendications 8 à 10, caractérisé par le fait que la durée du recuit est égale à au moins 30 minutes.

## FIG 1

## FIG 2

# FIG 3

# FIG 4